# EUROPÄISCHE PATENTSCHRIFT

(11) **EP 1 145 607 B1**
(45) Veröffentlichungstag und Bekanntmachung des Hinweises auf die Patenterteilung: **12.10.2011**
(21) Anmeldenummer: 99963506.3
(22) Anmeldetag: 11.12.1999
(51) Int. Cl.: H05K 3/00, G03F 7/16, G03F 7/38, G03F 7/40

(54) **HERSTELLUNG VON PHOTORESISTBESCHICHTUNGEN**
PRODUCTION OF PHOTORESIST COATINGS
OBTENTION DE COUCHES DE PHOTORESIST

(30) Priorität: 22.12.1998 CH 252998
(43) Veröffentlichungstag der Anmeldung: 17.10.2001
(73) Patentinhaber: Huntsman Advanced Materials (Switzerland) GmbH, 4057 Basel (CH)
(72) Erfinder: SETIABUDI, Frans, D-79427 Eschbach (DE)
(74) Vertreter: Hoffmann, Daniele
(86) Internationale Anmeldenummer: PCT/EP1999/009840
(87) Internationale Veröffentlichungsnummer: WO 2000/038487

(56) Entgegenhaltungen:
- EP-A- 0 346 522
- US-A- 5 319 861
- US-A- 5 372 915
- US-A- 5 527 659
- ROOS-KOZEL B L ET AL: "THE ADVANTAGES OF PROCESSING POLYMER THICK FILM MATERIALS IN AN INFRARED FURNACE" , PROCEEDINGS OF THE INTERNATIONAL SYMPOSIUM ON MICROELECTRONICS XP000671953 Seite 165 -Seite 175
- PATENT ABSTRACTS OF JAPAN vol. 017, no. 658 (P-1654), 6. Dezember 1993 (1993-12-06) & JP 05 216227 A (KONICA CORP), 27. August 1993 (1993-08-27)

## Beschreibung

Die vorliegende Erfindung betrifft ein Verfahren zur Herstellung einer Resistbeschichtung und die Verwendung dieses Verfahrens zur Herstellung einer Primärresistbeschichtung, einer Lötstoppresistbeschlchtung oder zum sequentiellen Aufbau von Mehrschichtenleiterplatten.

Resistbeschichtungen sind ein unerlässliches Werkzeug bei der Herstellung moderner Leiterplatten. Unter anderem wird hierbei zwischen sogenannten Primärresists und Lötstoppresists unterschieden.

Prlmärresists sind bildmässig strukturierte Beschichtungen auf einem Substrat, die bestimmte Teile dieses Substrats für einen vorübergehenden Zeitraum vor dem Einfluss einer bestimmten Behandlung schützen sollen, der das Substrat unterzogen wird, beispielsweise wenn ein kupferkaschiertes Laminat als Substrat einer Ätzbehandlung unterzogen werden soll, bei der das Kupfer von bestimmten Stellen des Laminats entfernt werden soll. Nach Beendigung dieser Behandlung werden die Primärresists im allgemeinen wieder völlig von dem Substrat entfernt. Die bildmässige Strukturierung der Primärresistbeschichtung wird i. a. durch bildmässige Belichtung einer geschlossenen Schicht des Resistmaterials auf dem Substrat erzeugt, die an den bestrahlten Stellen das Resistmaterial chemisch verändert. Mit Hilfe von geeigneten Entwicklern können dann entweder die bestrahlten oder die unbestrahlten Bereiche der Resistbeschichtung gelöst und das darunterliegende Substrat freigelegt werden. Bei bestimmten Resisttypen, z. B. chemisch verstärkten Resists, ist es erforderlich, die blidmässig belichtete Resistbeschichtung vor der Entwicklung noch einer längeren Erwärmung zu unterziehen, um eine ausreichende Differenzierung der Löslichkeiten von bestrahlten und unbestrahlten Material im Entwickler zu erreichen.

Lötstoppresists, die praktisch die gesamte Oberfläche einer fertig strukturierten und bestückten Leiterplatte bedecken, mit Ausnahme derjenigen Stellen, an denen während der abschliessenden Behandlung der Leiterplatte mit Lötmittel ein Kontakt der gedruckten Schaltung mit dem Lötmittel erwünscht ist, werden nach Abschluss dieser Behandlung im allgemeinen nicht mehr entfernt. Der Lötstoppresist verbleibt auf der Leiterplatte als Schutzbeschichtung u. a. gegen Umwelteinflüsse und zur elektrischen Isolierung der einzelnen Leiterbahnen der gedruckten Schaltung gegeneinander. Lötstoppresists enthalten häufig zusätzlich zu einem photohärtbaren Komponentensystem, das wie bei den Primärresists zur Strukturierung der Resistbeschichtung durch bildmässige Belichtung, gegebenenfalls Erwärmung der Resistbeschichtung, und Entwicklung eingesetzt wird, noch ein rein thermisch härtbares Komponentensystem, das erst nach der Strukturierung der Beschichtung, mit Hilfe von Wärme gehärtet wird, und das die Schutzeigenschaften der Beschichtung verbessert.

Wegen ihrer guten elektrischen Isolationseigenschaften finden Insbesondere Lötstoppresistzusammensetzungen auch beim sequentiellen Aufbau von Mehrschichtenlelterplatten Verwendung. Hierbei wird eine erste gedruckte Schaltung mit einer Photoresistbeschichtung als Isolationsschicht überzogen. Diese wird durch bildmässige Belichtung, gegebenenfalls Erwärmung der Resistbeschichtung, und Entwicklung in der Weise strukturiert, dass an den Stellen Löcher in der Isoaltionsschicht erzeugt werden, an denen später elektrische Verbindungen der ersten gedruckten Schaltung mit einem weiteren gedruckten Schaltkreis, der auf der Isolationsschicht aufgebracht wird, erforderlich sind. Danach wird die strukturierte Resistschicht, wenn erforderlich, thermisch gehärtet. Die Löcher in der isolierenden Resistschicht werden, z. B. durch Verkupfern, elektrisch leitend gemacht, und danach wird auf der Isolationsschicht die zweite gedruckte Schaltung in bekannter Weise aufgebaut. Der geschilderte Vorgang wird gegebenenfalls ein oder mehrere Male wiederholt, wobei Mehrschichtenleiterplatten erhalten werden.

Während bei Photoresistanwendungen, wie den oben genannten, "nicht thermische" Verfahrensschritte, wie z. B. die Photostrukturierung, im allgemeinen relativ schnell, z. B. innerhalb weniger Sekunden, ablaufen, erfordern die thermischen Behandlungsschritte einen wesentlich grösseren Zeitaufwand. Zu diesen thermischen Behandlungsschritten zählt beispielsweise die Vortrocknung der Resistbeschichtung auf dem Substrat, d. h. die Entfernung eines Lösungsmittels, das häufig als Carrier zur Applizierung der Reslstzusammensetzungen auf das Substrat dient, und die in üblichen Umluftöfen generell 20 bis 30 Minuten in Anspruch nimmt. Ein ähnlicher Zeitaufwand ist gegebenenfalls für die oben schon erwähnte Zwischenerwärmung der bestrahlen Resistbeschichtung vor der Entwicklung erforderlich. Ganz besonders zeitintensiv ist im allgemeinen aber die thermische Endhärtung von Lötstoppresistbeschichtungen, die im allgemeinen eine einstündige und noch längere Behandlung der Beschichtung bei Temperaturen im Bereich von ca. 150°C erfordert. Fliessbandanlagen, wie heute in der Leiterplattentechnologie allgemein üblich, können den Zeitbedarf für die thermischen Behandlungsschritte bei der Leiterplattenherstellung zwar kaschieren, benötigen aber dafür sehr grosse Öfen und/oder aufwendige Anlagen zur Führung des Fliessbandgutes in den Öfen, um sicherzustellen, dass die Platten bei einer gegebenen Fliessbandgeschwindigkeit lange genug in den Öfen verbleiben, um die thermische Behandlung zum Abschluss zu bringen.

In der EP-A-0115 354, Beispiel 1, ist bereits die Endhärtung einer fertig strukturierten Lötstoppmaskenbeschichtung mittels Infrarotstrahlung beschrieben, genaue Angaben über die Wellenlängen der verwendeten Infrarotstrahlung werden jedoch nicht gemacht. Aus den Angaben über die Geschwindigkeit, mit der die beschichteten Leiterplatten an der Infrarotstrahlungsquelle vorbeibewegt werden, ergibt sich, dass die Endhärtung einer üblichen Leiterplatte mindestens sechs Minuten oder länger dauert.

Der vorliegenden Erfindung liegt die überraschende Erkenntnis zugrunde, dass übliche Resistzusammensetzungen aufgrund der polaren Komponenten, die in ihnen enthalten sind, besonders gut Strahlung im Bereich des nahen Infrarots absorbieren, wobei sich die Zusammensetzungen so stark erwärmen, dass sich die oben genannten thermischen Behandlungsschritte innerhalb von 1 bis 60 Sekunden und oftmals in weniger als 10 Sekunden durchführen lassen. Ebenfalls überraschend kommt es hierbei zu keinen anwendungstechnischen Nachteilen, beispielsweise zu Lösungsmitteleinschlüssen bei der Vortrocknung oder zu vergösserter Sprödigkeit bei der thermischen Härtung. Ausserdem wird bei Einsatz von naher Infrarotstrahlung zur Endhärtung von Lötstoppresistschichten im allgemeinen ein wesentlich besserer Härtungsgrad erreicht.

Gegenstand der Erfindung ist daher ein Verfahren zur Herstellung einer Resistbeschichtung, bei dem
(a) ein Substrat mit einer Resistzusammensetzung beschichtet wird, die zumindest eine Komponente enthält, die Strahlung im Bereich des nahen Infrarots unter Erwärmung der Beschichtung absorbiert; und
(b) die Resistzusammensetzung oder eine hieraus abgeleitete, während des Verfahrens erhaltene Zusammensetzung im Verlaufe des Verfahrens mindestens einmal mit Hilfe von Strahlung im Bereich des nahen Infrarots einer thermischen Behandlung unterzogen wird.

Unter Strahlung im Bereich des nahen Infrarots wird in dieser Anmeldung insbesondere Strahlung einer Wellenlänge von 760 bis 1400 nm verstanden. Heizsysteme auf Basis dieser Strahlung sind seit längerem bekannt und werden z. B. von Research Inc., US oder INDUSTRIESERVIS, DE kommerziell vertrieben, wurden aber bisher noch nicht in der Resisttechnologie und bei der Herstellung elektrischer Leiterplatten eingesetzt. Vorzugsweise umfasst die erfindungsgemäss eingesetzte Strahlung im wesentlichen Strahlung einer Wellenlänge von 760 bis 999 nm.

Die Strahler für die nahe Infrarotstrahlung werden erfindungsgemäßes so angebrancht, dass sie die ganze Breite eines darunter durchgeführten Fliessbandes bestrahlen, auf dem die mit der Resistbeschichtung versehenen Substrate, z. B. die Leiterplatten vorwärts bewegt werden. Gegebenenfalls müssen mehrere Strahler nebeneinander angebracht werden. Der Abstand zwischen den Strahlern und dem Band und die Stromleistung, mit der die Strahler betrieben werden, wird vorzugsweise in Abhängigkeit von weiteren Verfahrensparametern, u. a. der speziellen Resistzusammensetzung, der Dicke der Resistschicht, die thermisch behandelt werden soll, und der für die angestrebte thermische Reaktion geeignetesten Temperatur, optimiert, was dem Fachmann mit wenigen einfachen Versuchen möglich ist.

Es gibt keine speziellen Beschränkungen für die Art der Resistzusammensetzung, die in dem erfindurigsgemässen Verfahren zum Einsatz kommen können, oder ihre Bestandteile. Die Anwendung der Resistzusammensetzung muss jedoch zumindest einen thermischen Verfahrensschritt aufweisen, wenn die Vorteile des erfindungsgemässen Verfahrens zum Tragen kommen sollen. Weiterhin muss gewährleistet sein, dass die Resistzusammensetzung Strahlung im Bereich des nahen Infrarots unter Erwärmung absorbiert. Aus diesem Grunde sollte sie zweckmässigerweise Bestandteile mit polaren funktionellen Gruppen aufweisen, die von der Strahlung im Bereich des nahen Infrarot zu Wärmeschwingungen angeregt werden können. Dies trifft für praktisch alle in der Leiterplattentechnologie üblichen Resistzusammensetzungen zu. Bevorzugt enthalten die im erfindungsgemässen Verfahren einzusetzenden Zusammensetzungen jedoch zumindest eine vernetzbare Verbindung, die (Meth)acryl- oder Epoxidgruppen, aufweist.

Die beim erfindungsgemässen Verfahren eingesetzten Resistzusammensetzungen enthalten zumindest ein photoempfindliches Komponentensystem. "Photoempfindlich" bedeutet für die Zwecke dieser Anmeldung, empfindlich für UV und/oder VIS Strahlung.

Bei dem photoempfindlichen Komponentensystem kann es sich z. B. um ein chemisch verstärktes positiv arbeitendes System handeln, d. h. ein System, dass nach bildmässiger Belichtung der Beschichtung und einer thermischen Behandlung der Schicht an den bestrahlten Stellen im entwickler löslicher ist als an den nicht bestrahlten Stellen. Positivresists auf Basis eines photoempfindlichen Komponentensystems dieses Typs sind z. B. in der EP-A-0 568 827 beschrieben. In der EP-A-0 295 211 ist ein anderer Typ von Positivresist beschrieben, für dessen Anwendung das erfindungsgemässe Verfahren ebenfalls erhebliche Zeitvorteile bringt, und der sich insbesondere auch für den sequentiellen Aufbau von Mehrschichtenleiterplatten eignet. Bei diesem Positivresist wird der in der Zusammensetzung enthaltene Katalysator für eine thermische Vernetzung der Zusammensetzung durch eine Bestrahlung unwirksam gemacht und anschliessend eine thermische Härtung der bildmässig belichteten Resistbeschichtung durchgeführt, die demgemäss nur zu einer Härtung der nicht belichteten Bereiche der Beschichtung und somit nach Entwicklung-zu einem positiven Maskenabbild in der Resistschicht führt. Der hierbei erforderliche thermische Härtungsschrift, der in herkömmlicher Weise etwa 15 bis 30 Minuten benötigt, kann durch den Einsatz von Strahlung im Bereich des nahen infrarots ebenfalls auf einige Sekunden verkürzt werden.

Das erfindungsgemässe Verfahren kann weiterhin für Negativresists angewandt werden, die ein photohärtbares bzw. photovemetzbares Komponentensystem aufweisen. "Photohärtbar" bzw. "photovernetzbar" soll in dieser Anmeldung, wenn nichts anderes angegeben ist, ebenfalls härtbar bzw. vernetzbar mit Hilfe von UV und/oder VIS Strahlung bedeuten. Ein häufig für Negativresists eingesetztes photohärtbares Komponentensystem basiert z. B. auf einem radikalischen Photoinitiator und photopolymerisierbaren Monomeren und/oder Oligomeren, z. B. Vinyl- oder (Meth)acrylatmonomeren und/oder -oligomeren als vernetzbarem Bestandteil, beispielsweise Diethylenglycoldiacrylat, Trimethylobropantriacrylat oder Pentaerythritoltriacrylat. Als Photoinitiatoren lassen sich hierbei alle üblichen Initiatoren für die radikalische Photopolymerisation in den hierfür bekannten und üblichen Mengen einsetzen. Gewünschtenfalls können zusätzlich Coinitiatoren eingesetzt werden. Ein Negativresist dieses Typs ist beispielsweise im US-Patent US-A-5,045,435 beschrieben. Das erfindungsgemässe Verfahren eignet sich aber auch für kationisch photopolymerisierbare Resisttypen, z. B. auf Basis von Oniumsalzen als Photoinitiatoren, wie z. B. Sulfoniumsalzen, und Verbindungen mit mehr als einer Epoxidgruppe pro Molekül. Auch diese Resisttypen müssen zwischen der bildmässigen Belichtung und Entwicklung im aligemeinen noch einer längeren Erwärmung auf Temperaturen über 80 bis 100 °C unterzogen werden, die bei erfindungsgemässem Einsatz von Strahlung des nahen Infrarotbereichs zur Erwärmung der Resistschicht ebenfalls nur wenige Sekunden benötigt.

Insbesondere für die Herstellung von Lötstoppresists oder zum sequentiellen Aufbau von Leiterplatten, eignen sich Resistzusammensetzungen, die ein photohärtbares Komponentensystem sowie ein thermisch härtbares Komponentensystem enthalten. Das thermisch härtbare komponentensystem kann z. B. auf einer Epoxidverbindung und einem Härter hierfür basieren, insbesondere einem latenten Härter, wie z. B. Dicyandiamid, gegebenfalls in Gegenwart von Chlortoluron als Beschleuniger. Weitere unter anderem besonders für die Herstellung von Lötstoppmasken geeignete Resistzusammensetzungen sind z. B. in der EP-A-0115 354 (auf Basis organischer Lösungsmittel) oder in der EP-A-0 493 317 (auf Basis von Wasser als Carrier) beschrieben.

Die Beschichtung des Substrats mit der Resistzusammensetzung kann mittels der üblichen Verfahren, mit denen eine Beschichtung gleichförmig aufgebracht werden kann. Beispiele für solche Beschichtungsverfahren sind Aufschleudem, Aufpinsein, Aufsprühen, z. B. elektrostatisches Aufsprühen, Reverse-Rollbeschichtung, Tauch- und Rakelbeschichtung und das Vorhanggiessverfahren. Die Auftragsmenge (Schichtdicke) und die Art des Substrates (Schichtträger) sind abhängig vom gewünschten Applikationsgebiet. Im allgemeinen sollte die Dicke der Schicht vor Entfernen des Lösungsmittels etwa 5 bis 150 mm betragen, bevorzugt etwa 25 bis 100 mm, insbesondere 25 bis 75 mm.

Enthält die Resistzusammensetzung ein Lösungsmittel, beispielsweise ein inertes organisches Lösungsmittel, Wasser oder ein Gemisch von zwei oder mehr als zwei der genannten Komponenten, wird das Lösungsmittel nach Beschichtung des Substrats bevorzugt durch eine thermische Behandlung der Zusammensetzung mit Strahlung im Bereich des nahen Infrarots unter Bildung der Resistbeschichtung entfernt. Die Leistungsaufnahme und Abstand der Strahler vom beschichteten Substrat werden vorzugsweise so abgestimmt, dass die Vortrocknung unter Bildung einer Resistbeschichtung auf dem Substrat während 1 bis 30 Sekunden, insbesondere während 3 bis 10 Sekunden erfolgt. Ein weiterer zeitlicher Vorteil des erfindungsgemässen Einsatzes von Strahlung des nahen Infrarotbereichs bei der Vortrocknung besteht darin, dass sich das Substrat aufgrund der kurzen Erwärmungszeit nur auf eine Temperatur von ca. 40 bis 50°C, erwärmt, so dass im Gegensatz zur herkömmlichen Vortrocknung, wo das Substrat am Ende der Vortrocknung im allgemeinen die Ofentemperatur von etwa 100 bis 140°C aufweist, sofort mit einer eventuellen Beschichtung der zweiten Seite einer Leiterplatte mit frischer Resistzusammensetzung begonnen werden kann, ohne dass es nötig wäre die Leiterplatte wie bisher mehrere Minuten abkühlen zu lassen, um die Leiterplatte nicht der Gefahr thertmomechanischer Beschädigungen durch Apparatureinwirkungen auszusetzen.

Besonders bevorzugt erfolgt die Entfernung des Lösungsmittels während der Vortrocknung unter gleichzeitiger Behandlung der Oberfläche der Beschichtung mit einem Gasstrom, wobei es sich bei dem Gas insbesondere um strömende Luft handelt Die Behandlung der Beschichtung mit dem strömenden Gas kann beispielsweise mit einem üblichen Luftmesser erfolgen.

Die erfindungsgemässe Vortrocknung mit Hilfe von Strahlung im Bereich des nahen Infrarot zur Entfernung des Lösungsmittels kommt sowohl für Primärresistzusammensetzungen als auch für Lötstoppresistzusammensetzungen in Frage.

Das mit der Zusammensetzung beschichtete Substrat kann nach Entfernung von in der Zusammensetzung enthaltenen Lösungsmittel in üblicher Weise mit UVNIS-Strahlung bildmässig belichtet und danach mit Hilfe eines geeigneten Entwicklers gemäss diesem Bild strukturiert werden, wie es in diesem Fachgebiet allgemein üblich ist. Die bildmässige Belichtung kann z. B. mit Hilfe einer Maske erfolgen, die vorzugsweise auf die vorgetrocknete Resistbeschichtung gelegt wird, oder mit einem Laserstrahl, der so über die Beschichtung geführt wird, das eine bildmässige Bestrahlung der Beschichtung erfolgt. Eine Erwärmung, die nach der Belichtung gegebenenfalls noch erforderlich ist, um einer genügende Löslichkeitsdifferenz zwischen bestrahlten und unbestrahlten Bereichen der Resistschicht zu erreichen, wird erfindungsgemäss bevorzugt ebenfalls mit Hilfe von Strahlung des nahen infrarotbereichs durchgeführt. Eine hierzu ausreichende Erwärmung kann der Beschichtung kann im aligemeinen ebenfalls während eines Zeitraums von wenigen Sekunden, z. B. während 1 bis 30 Sekunden, insbesondere während 1 bis 10 Sekunden erfolgen. Gegebenenfalls müssen Intensität und Zeitdauer der Bestrahlung mit einigen Versuchen so optimiert werden, dass ein in dem Resist gegebenenfalls vorhandenes zusätzliches thermisch härtbares Komponentensystem während dieses Verfahrensschrittes noch nicht so weit anspringt, dass eine Strukturierung der Beschichtung durch die nachfolgende Entwicklung nicht verhindert wird.

Wird das erfindungsgemässe Verfahren für die Aufbringung eines Resists eingesetzt, der zusätzlich zum photovernetzbaren Komponentsystem ein rein thermisch verrietzbares Komponentensystem enthält, also z. B. für die Aufbringung eines Lötstoppresists, so kann nach der bildmässigen Strukturierung der Resistbeschichtung durch Belichtung und gegebenenfalls Erwärmung sowie Entwicklung das thermisch härtbare Komponentensystem der Resistzusammensetzung zur Reaktion gebracht werden.

Bevorzugt wird das thermisch härtbare Komponentensystem der Resistzusammensetzung ebenfalls mit Strahlung im Bereich des nahen Infrarots gehärtet. Hierbei zeigt das erfindungsgemässe Verfahren sich die grössten zeitlichen Vorteile gegenüber der herkömmlichen Erstellung von Lötstoppreslstbeschichtungen, bei der konventlonelle thermische Härtungstechniken zum Einsatz kommen, da sich die herkömmlicherweise übliche Härtungszeit von etwa einer Stunde auf ca. 5 Sekunden, d. h. um mehr als das Siebenhunderfache, senken lässt.

Das erfindungsgemässe Verfahren kann überall eingesetzt werden, wo Resists, insbesondere Photoresists zum Einsatz kommen, insbesondere zur Herstellung von Primärresistbeschichtungen und Lötstoppresistbeschichtungen bei der Leiterplattenherstellung sowie zum zum sequentiellen Aufbau von Mehrschichtemleiterplatten mit Hilfe von Resists.

### Beispiel:

Eine Harzmischung wird hergestellt, indem man 28,62 g Tris(2-hydroxyethyl)isocyanurat triacrylat (SR 368 ex Cray Valley/Paris), 27,53 g Bindemittel (erhalten durch dreistündiges Erhitzen von 467 g Bisphenol-A-diglycidylether vom Epoxidgehalt 5,26 bis 5,38 val/kg, 333 g Tetrabrombisphenol A, 200 g Triglycidylisocyanurat und 0,05 2-Phenylimidazol auf 160°C gemäss EP-A-0 559 607, Beispiel 1, und anschliessende Vermischung des hierbei erhaltenen Umsetzungsprodukts nach Abkühlung auf ca. 150°C mit 125 g Methylethylketon), 3,63 g ethoxyliertes Trimethylolpropantriacrylat (SR 454 ex Cray Valley/Paris), 0,18 g Byk 077 (Entschäumer von Byk Chemie) und 0,01 g Hydrochinon in 16,45 g Propylenglycolmethyletheracetat bei 45 - 50°C löst. 5,02 g Irgacure 819 (Photoinitiator auf Basis von Phosphinoxid) und 0,65 g Dicyandiamid (mikrofein) werden zugegeben und die Mischung wird mit einem Dissolver homogenisiert. Anschliessend fügt man ohne weiteres Heizen 17,91 g Talkum zu. Nach Abkühlen auf Raumtemperatur wird die homogene Mischung gemahlen.

Zur Herstellung einer Härtermischung löst man unter Rühren 1,56 g 2,4,6-Trimercapto-s-triazin (ZISNET F ex Sankyo Kasei Co.Ltd., Japan) und 0,11 g Chlortoluron in 27,88 g Dowanol PB 40 (Mischung aus Propylenglykolmethylether und Propylenglykolbutylether ex DOW). Dann gibt man 0,11 g Orasol Blau zu und rührt weitere 10 Minuten. Nach Abkühlen auf Raumtemperatur fügt man 0,33 g des Tensids/Netzmittels FC 431 (ex 3M) zu.

Man stellt eine Lötstoppzusammensetzung aus 100 g der Harzmischung und 26.9 g Härtermischung her. Eine mit Kupfer kaschierte Laminatplatte wird mit der Zusammensetzung auf einer K Control Coater Anlage Model 625 K303 beschichtet. (Einstellung der Beschichtungsanlage: K 202 Rackelaufsatz Stab Nr.9 =125 Micrometer; Aufziehgeschwindigkeit 5m/min). Das frisch beschichtete Kupferlaminat wird 20 Minuten an der Luft stehen gelassen und anschliessend 30 Minuten bei 80°C getrocknet.

Danach wird das Kupferlaminat mit UV Licht einer Energie von 1500 mJ/cm² durch eine strukturierte Maske belichtet. Die Entwicklung der Lötstoppmaske erfolgt mit Gamma-Butyrolacton.

Die volle Endhärtung der Lötstoppbeschichtung erfolgt mit Hilfe einer Nahinfrarotbelichtungsanlage der Fa.IndustrieSerVis/Bruckmühl-Deutschiand Innerhalb 20 - 28 Sekunden, wobei ein Bestrahlungssystem bestehend aus einem wassergekühlten Nahinfrarot-Heizmodul (120 mm x 250 mm) mit sechs Hochleistungshalogenlampen (2x 2 kW äussere Lampen und 4x1 kW innere Lampen) ausgerüstet zum Einsatz kommt und der Abstand zwischen den Halogenlampen und dem beschichteten Kupferlaminat 12 cm beträgt.

Eine Prüfung der Lötstoppbeschichtung ergibt folgende Eigenschaften:
Bleistifthärte (Mitsubishi Bleistift): 6H;
Gitterschnittkennwert nach DIN 53151: 1 bis 2;
Methylenchloridstabilität:
Das zu testende Kupferlaminat wird bei Raumtemperatur in Methylenchlorid getaucht Erst nach 40 Min erkennt man erste Bläschen an der Oberfläche der Lötstoppbeschichtung.

## Patentansprüche

1. Verfahren zur Herstellung einer Resistbeschichtung, bei dem
(a) ein Substrat mit einer Resistzusammensetzung beschichtet wird, die zumindest eine Komponente enthält, die Strahlung im Wellenlängenbereich von 760 bis 1400 nm unter Erwärmung der Beschichtung absorbiert; und
(b) die Resistzusammensetzung oder eine hieraus abgeleitete, während des Verfahrens erhaltene Zusammensetzung, im Verlauf des Verfahrens mindestens einmal mit Hilfe von Strahlung im Wellenlängenbereich von 760 bis 1400 nm einer thermischen Behandlung unterzogen wird, wobei die Strahler für die Strahlung im Wellenlängenbereich von 760 bis 1400 nm so angebracht sind, dass sie die ganze Breite eines darunter durchgeführten Fliessbandes bestrahlen, auf dem die mit der Resistbeschichtung versehenen Substrate vorwärts bewegt werden **dadurch gekennzeichnet, dass** die thermische Behandlung innerhalb von 1 bis 60 Sekunden durchgeführt wird und die Resistzusammensetzung ein photohärtbares Komponentensystem sowie ein rein thermisch härtbares Komponentensystem enthält.

2. Verfahren nach Anspruch 1, **dadurch gekennzeichnet, dass** die Zusammensetzung ein Lösungsmittel enthält und das Lösungsmittel durch eine thermische Behandlung der Zusammensetzung mit Strahlung im Wellenlängenbereich von 760 bis 1400 nm unter Bildung der Resistbeschichtung entfernt wird.

3. Verfahren nach Anspruch 2, **dadurch gekennzeichnet, dass** die Entfernung des Lösungsmittels unter gleichzeitiger Behandlung der Oberfläche der Beschichtung mit strömenden Gas erfolgt.

4. Verfahren nach Anspruch 3, **dadurch gekennzeichnet, dass** das strömende Gas Luft ist.

5. Verfahren nach einem der Ansprüche 1 bis 4, **dadurch gekennzeichnet, dass** die Zusammensetzung ein inertes organisches Lösungsmittel, Wasser oder ein Gemisch von zwei oder mehr als zwei der genannten Komponenten enthält.

6. Verfahren gemäß einem der Ansprüche 1 bis 5, **dadurch gekennzeichnet, dass** das mit der Zusammensetzung beschichtete Substrat nach Entfernung von in der Zusammensetzung enthaltenen Lösungsmittel mit UV/VIS-Strahlung bildmässig belichtet wird und, gegebenenfalls nach einer Erwärmung, mit Hilfe eines Entwicklers gemäss diesem Bild strukturiert wird.

7. Verfahren nach Anspruch 6, **dadurch gekennzeichnet, dass** die Erwärmung zwischen bildmässiger Belichtung und Entwicklung mit Hilfe von Strahlung im Wellenlängenbereich von 760 bis 1400 nm erfolgt.

8. Verfahren nach einem der Ansprüche 6 oder 7, **dadurch gekennzeichnet**, das nach der bildmässigen Strukturierung der Resistbeschichtung das rein thermisch härtbare Komponentensystem der Resistzusammensetzung gehärtet wird.

9. Verfahren nach Anspruch 8, **dadurch gekennzeichnet, dass** das rein thermisch härtbare Komponentensystem der Resistzusammensetzung mit Hilfe von Strahlung im Wellenlängenbereich von 760 bis 1400 nm gehärtet wird.

10. Verfahren nach einem der Ansprüche 1 bis 9, **dadurch gekennzeichnet, dass** die Resistzusammensetzung zumindest eine vernetzbare Verbindung enthält, die (Meth) acryl- oder Epoxidgruppen aufweist.

11. Verfahren nach einem der Ansprüche 1 bis 10, **dadurch gekennzeichnet, dass** die Zusammensetzung ein thermisch härtbares Komponentensystem auf Basis einer Epoxidverbindung enthält.

12. Verwendung eines Verfahrens gemäss einem der Ansprüche 1 bis 11 zur Herstellung einer Primärresistbeschichtung, einer Lötstoppresistbschichtung oder beim sequentiellen Aufbau von Mehrschichternleiterplatten.

## Claims

1. A process for the production of a resist coating, in which
(a) a substrate is coated with a resist composition which comprises at least one component that absorbs radiation in a wavelength region of 760 to 1400 nm with warming of the coating; and
(b) said resist composition or a composition derived therefrom and obtained during the process is subjected at least once during the process to thermal treatment with the aid of radiation in the wavelength region of 760 to 1400 nm, wherein the emitters for said radiation in a wavelength region of 760 to 1400 nm are arranged to irradiate the whole width of a conveyor belt passing along beneath on which the substrates provided with the resist coating are advanced, **characterized in that** said thermal treatment is performed within 1 to 60 seconds, and said resist composition includes a photocurable component system and a purely thermally curable component system.

2. The process according to claim 1, **characterized in that** said composition comprises a solvent, and the solvent is removed by thermal treatment of the composition with radiation in the wavelength region of 760 to 1400 nm with formation of the resist coating.

3. The process according to claim 2, **characterized in that** the removal of the solvent is carried out with simultaneous treatment of the surface of the coating with flowing gas.

4. The process according to claim 3, **characterized in that** the flowing gas is air.

5. The process according to any of claims 1 to 4, **characterized in that** the composition comprises an inert organic solvent, water or a mixture of two or more than two of the said components.

6. The process according to any of claims 1 to 5, **characterized in that** the substrate coated with the composition, after removal of any solvent present in the composition, is exposed imagewise to UV/VIS radiation and, if desired after heating, is structured in accordance with this image with the aid of a developer.

7. The process according to claim 6, **characterized in that** the heating between the imagewise exposure and the development is carried out with the aid of radiation in the wavelength region of 760 to 1400 nm.

8. The process according to either of claims 6 or 7, **characterized in that**, after the imagewise structuring of the resist coating, the purely thermally curable component system of the resist composition is cured,

9. The process according to claim 8, **characterized in that** the purely thermally curable component system of the resist composition is cured with the aid of radiation in the wavelength region of 760 to 1400 nm.

10. The process according to any of claims 1 to 9, **characterized in that** the resist composition comprises at least one crosslinkable compound containing (meth)acrylic or epoxide groups.

11. The process according to any of claims 1 to 10, **characterized in that** the composition comprises a thermally curable component system based on an epoxide compound.

12. Use of a process according to any of claims 1 to 11 for preparing a primary resist coating, a solder-stop resist coating, or in the sequential construction of multilayer circuit boards.

## Revendications

1. - Procédé de fabrication d'un revêtement de résist selon lequel,
(a) un substrat est revêtu d'une composition de résist qui contient au moins un composant qui absorbe le rayonnement dans la plage de longueur d'onde allant de 760 à 1400 nm lors du chauffage du revêtement ; et
(b) la composition de résist ou une composition issue de celle-ci obtenue durant le procédé est soumise au moins une fois, au cours du procédé, à un traitement thermique au moyen d'un rayonnement dans la plage de longueur d'onde allant de 760 à 1400 nm, les émetteurs du rayonnement dans la plage de longueur d'onde allant de 760 à 1400 nm étant conçus de telle sorte qu'ils irradient la largeur entière d'une chaîne mise en oeuvre au-dessous, sur laquelle des substrats munis du revêtement de résist se déplacent vers l'avant,
**caractérisé par le fait que** le traitement thermique est réalisé en un temps de 1 à 60 secondes et la composition de résist contient un système de composants photodurcissable ainsi qu'un système de composants durcissable de façon purement thermique.

2. - Procédé selon la revendication 1, **caractérisé par le fait que** la composition contient un solvant et le solvant est éliminé par un traitement thermique de la composition par un rayonnement dans la plage de longueur d'onde allant de 760 à 1400 nm avec formation du résist.

3. - Procédé selon la revendication 2, **caractérisé par le fait que** l'élimination du solvant est réalisée avec traitement simultané de la surface du revêtement par un courant gazeux.

4. - Procédé selon la revendication 3, **caractérisé par le fait que** le courant gazeux est constitué d'air.

5. - Procédé selon l'une des revendications 1 à 4, **caractérisé par le fait que** la composition contient un solvant organique inerte, de l'eau ou un mélange de deux ou plus de deux des composants cités.

6. - Procédé selon l'une des revendications 1 à 5, **caractérisé par le fait que** le substrat revêtu de la composition est éclairé selon une image par rayonnement UV/VIS après élimination du solvant contenu dans la composition et, le cas échéant, est structuré selon cette image à l'aide d'un développeur après un chauffage.

7. - Procédé selon la revendication 6, **caractérisé par le fait que** le chauffage est réalisé entre l'éclairement selon une image et le développement au moyen d' un rayonnement dans la plage de longueur d'onde allant de 760 à 1400 nm.

8. - Procédé selon l'une des revendications 6 ou 7, **caractérisé par le fait qu'**après la structuration du revêtement de résist selon une image, le système de composants durcissable de manière purement thermique de la composition de résist est durci.

9. - Procédé selon la revendication 8, **caractérisé par le fait que** le système de composants durcissable de manière purement thermique de la composition de résist est durci au moyen d'un rayonnement dans la plage de longueur d'onde allant de 760 à 1400 nm.

10. - Procédé selon l'une des revendications 1 à 9, **caractérisé par le fait que** la composition de résist contient au moins un composé réticulable qui comprend des groupes méthacryliques ou époxydes.

11. - Procédé selon l'une des revendications 1 à 10, **caractérisé par le fait que** la composition contient un système de composants durcissable thermiquement à base d'un composé époxyde.

12. - Utilisation d'un procédé selon l'une des revendications 1 à 11, dans la fabrication d'un revêtement de résist primaire, d'un revêtement de résist d'arrêt de brasage ou dans la construction séquentielle de plaques conductrices à plusieurs couches.
